# FASCICULE DE BREVET EUROPEEN

(11) **EP 3 942 575 B1**
(45) Date de publication et mention de la délivrance du brevet: **07.05.2025**
(21) Numéro de dépôt: 20726207.2
(22) Date de dépôt: 16.03.2020
(51) Int. Cl.: H01B 5/12, H02G 3/04, D03D 1/00

(54) **GAINE DE BLINDAGE MAGNÉTIQUE POUR UN CÂBLE ÉLECTRIQUE**
MAGNETISCHE ABSCHIRMHÜLLE FÜR EIN ELEKTRISCHES KABEL
MAGNETIC SHIELDING SHEATH FOR AN ELECTRICAL CABLE

(30) Priorité: 19.03.2019 FR 1902827
(43) Date de publication de la demande: 26.01.2022
(73) Titulaire: Tresse Industrie, 63600 Ambert (FR)
(72) Inventeur: CLEMENT, Gilles, 63600 AMBERT (FR); OMERIN, Pierre, 63600 AMBERT (FR)
(74) Mandataire: Germain Maureau
(86) Numéro de dépôt international: PCT/FR2020/050551
(87) Numéro de publication internationale: WO 2020/188213

(56) Documents cités:
- EP-A1- 2 903 006
- EP-A1- 2 903 006
- EP-A2- 2 869 416
- WO-A1-02/054554
- WO-A2-2007/117883
- WO-A2-2007/117883
- DE-A1- 102014 104 290
- DE-A1- 102016 107 453
- JP-A- 2004 214 137
- US-B2- 8 283 563
- US-B2- 9 496 071

## Description

La présente invention concerne une gaine de blindage magnétique pour un câble électrique.

Certaines installations comportent un ou plusieurs objets qui génèrent un champ électromagnétique pouvant nuire au bon fonctionnement de certains équipements électriques ou électroniques et/ou être nocif pour les personnes situées à proximité. Il est alors connu de mettre en place un blindage, qui forme une barrière entre l'objet source de ce champ électromagnétique et les équipements ou personnes à protéger.

L'invention concerne plus spécifiquement le blindage d'un câble, c'est-à-dire le blindage contre un champ électromagnétique émis par un câble traversé par un courant. En courant continu, ou à basse voire très basse fréquence (de l'ordre de 0 Hz à 500 kHz), la dominante de ce champ est magnétique.

Le document WO 2007/117883 décrit un manchon protecteur fabriqué avec un fil hybride présentant des filaments de câbles.

L'invention s'applique en particulier, mais non exclusivement, aux véhicules hybrides, c'est-à-dire incluant, en plus d'un moteur thermique, un moteur électrique lié à un générateur tel qu'une batterie. Le montage électrique est typiquement de type mode commun, c'est-à-dire que le courant revient au générateur par la masse. En pratique, le châssis du véhicule constitue le plan de masse.

Dans cette application, le champ électromagnétique provient du câble, qui est traversé par un fort courant permanent, et peut en outre être traversé ponctuellement par des pointes de courant d'appel de très faible durée (quelques millisecondes) mais de très forte intensité (par exemple de l'ordre de 500 à 600 A), typiquement lors du démarrage. Ce sont ces pointes de courant d'appel qui génèrent le champ magnétique le plus important, contre lequel le blindage est crucial.

Les solutions connues de blindage magnétique sont basées sur la réalisation de coffrets, ce qui est inenvisageable dans l'espace confiné qu'est un habitacle de véhicule. En outre, ces méthodes mettent en œuvre des matériaux à très forte perméabilité relative µr, comme le mumétal ou le permalloy, qui sont peu modelables, sauf à mettre en œuvre de très coûteuses opérations de traitement. Ainsi, ces solutions de blindage magnétique ne conviennent pas à toutes les installations, et en particulier ne peuvent pas être transposées au blindage d'un câble dans un véhicule.

La présente invention vise à remédier à tout ou partie des inconvénients mentionnés ci-dessus, en fournissant une solution améliorée de blindage magnétique de câble électrique.

A cet effet, et selon un premier aspect, l'invention concerne une gaine de blindage magnétique pour un câble électrique conforme à la revendication 1.

L'invention fournit ainsi un blindage contre le champ électromagnétique émis par le câble logé dans la gaine, en particulier contre la composante magnétique de ce champ.

De façon concrète, grâce aux éléments allongés réalisées en matériau électriquement conducteur, la gaine forme un conducteur de retour pour le courant acheminé à l'aller par le câble logé dans la gaine. Dans l'application à un véhicule dont le châssis forme le plan de masse, le chemin de retour vers le générateur est formé de préférence sensiblement exclusivement par cette gaine plutôt que par le châssis, dans la mesure où ce dernier est de structure hétérogène (présence de soudure, orifices, fentes ; assemblage de parties en matériaux différents, éventuellement non métalliques) et présente donc une forte impédance. Il s'ensuit que le courant dans la gaine de blindage crée un champ magnétique opposé au champ magnétique perturbateur créé par le courant circulant dans le câble et permet de l'atténuer partiellement. Le champ magnétique résultant de la somme du champ perturbateur et du champ créé par le courant de retour dans la gaine est donc moins intense. Cette atténuation est d'autant plus importante que la gaine et le câble sont proches l'un de l'autre.

Par ailleurs, les éléments allongés réalisées en matériau ayant des propriétés magnétiques permet de réaliser le blindage contre le champ magnétique résultant.

L'utilisation d'éléments allongés et leur mode d'assemblage par enroulement ou entrecroisement présente de nombreux avantages. En particulier, cela permet d'obtenir une structure flexible, c'est-à-dire que la gaine présente une souplesse lui permettant d'être déformée, pour suivre le trajet du câble et s'adapter aux contraintes spatiales de l'installation dans laquelle elle est mise en place. Le travail du matériau en éléments allongés permet de conserver leurs propriétés magnétiques ou de les restaurer par des traitements adaptés, à un coût acceptable.

Selon l'invention, la gaine est constituée par un tel assemblage d'éléments allongés.

En pratique, le terme « type » peut faire référence au matériau constitutif des éléments allongés, duquel découlent les propriétés de conductivité et les propriétés magnétiques. Il peut aussi faire référence à la structure ou à la géométrie des éléments allongés (comme la forme ou le diamètre de ces éléments).

S'agissant de l'assemblage des éléments allongés, l'assemblage de façon entrecroisée signifie que les éléments flexibles sont croisés ensemble à plusieurs reprises ; l'assemblage formant un enlacement signifie que les éléments flexibles entourent plusieurs fois le câble, éventuellement avec un certain serrage. L'assemblage des éléments allongés implique de préférence un certain ordonnancement dans l'espace, à l'opposé d'un emmêlement ou d'un enchevêtrement des éléments allongés. Les éléments allongés d'un type donné peuvent être assemblés de façon entrecroisée et/ou en formant un enlacement seulement avec les éléments allongés du même type, ou en variante également avec les éléments allongés de l'autre type.

Le fait que la gaine est réalisée sous la forme d'une nappe initialement sensiblement plane présente un certain nombre d'avantages.

Une telle nappe est un produit complètement séparé du câble. La nappe peut ainsi être fabriquée et stockée indépendamment du câble, et mise en place autour du câble ultérieurement, contrairement à une structure complexe coaxiale de câble comportant une gaine sous forme de couche de protection incluse dans ladite structure complexe. L'invention apporte ainsi une grande simplification dans la fabrication et offre davantage de modularité par rapport à une structure complexe dans laquelle la gaine est déjà incluse.

En outre, puisque la nappe vient s'enrouler autour du câble, il se crée facilement dans la nappe des passages par lesquels le câble peut entrer dans la gaine et en ressortir, par exemple le long de bords de la nappe placés en regard l'un de l'autre lorsque la nappe est mise en place. Ainsi, d'une part, il n'est pas nécessaire de pratiquer des ouvertures dans la gaine, ce qui nécessiterait un temps additionnel de mise en œuvre et pourrait créer des zones de faiblesse dans la gaine. D'autre part, les passages créés par l'enroulement de la nappe peuvent se situer en différents endroits de la nappe, par exemple potentiellement tout le long de deux bords longitudinaux de la nappe en regard l'un de l'autre une fois la nappe enroulée. Ceci offre une grande flexibilité sur le positionnement des zones d'entrée et de sortie du câble, et donc une grande adaptabilité aux différentes contraintes de montage.

De plus, la nappe, étant initialement indépendante du câble, peut être fabriquée selon les besoins exacts, correspondant au blindage que l'on souhaite obtenir pour chaque cas. Ainsi, l'invention permet une grande modularité et une grande adaptabilité par le choix de la structure de gaine la plus appropriée, notamment en termes de moyens d'assemblage des éléments allongés, choix de la section, etc.

De façon concrète, les éléments allongés du premier type et/ou du deuxième type peuvent être métalliques.

Les éléments allongés du premier type peuvent être réalisés en au moins un matériau possédant une conductivité électrique relative σr supérieure à 0,5, de préférence supérieure à 0,6, à température ambiante. Ledit matériau est par exemple le cuivre ou l'aluminium. On rappelle que la conductivité électrique relative σr d'un matériau est un nombre sans dimension défini comme la conductivité électrique du matériau divisée par la conductivité électrique du cuivre.

Les éléments allongés du deuxième type sont réalisés en au moins un matériau possédant une perméabilité magnétique relative µr comprise entre µr min et µr max, où, à température ambiante, et dans une gamme de fréquences comprises entre 0 Hz et 500 kHz :
- µr min vaut 50, de préférence 100, mieux encore 200, voire 500 ;
- µr max vaut 7000, de préférence 6000, mieux encore 5500, voire 1000.

On rappelle que la perméabilité magnétique relative µr d'un matériau est un nombre sans dimension défini comme la perméabilité magnétique du matériau divisée par la perméabilité magnétique du vide µ0.

Les éléments allongés du deuxième type sont par exemple réalisés en un matériau appartenant au groupe formé par : le fer, le nickel, le cobalt et leurs alliages. De préférence, les éléments allongés du deuxième type ne sont réalisés ni en mumétal ni en permalloy.

Les éléments allongés peuvent être de section ronde, ou de section rectangulaire, de préférence rectangulaire aplatie. On peut prévoir que les éléments allongés appartiennent au groupe comprenant : les fils de section ronde, les fils méplats, les feuillards, notamment les feuillards laminés. Le terme « feuillard » désigne une bande étroite et plate.

Dans la nappe, les éléments allongés peuvent être assemblés par tressage, tricotage, tissage, et/ou guipage (c'est-à-dire l'assemblage d'un fil en âme avec un fil enroulé autour).

De préférence, dans la nappe, les éléments allongés sont sensiblement jointifs. En d'autres termes, la nappe ne comprend pas un réseau régulier de trous, comme dans un treillis.

Selon l'invention, la nappe est configurée pour être enroulée autour du câble en partant d'une forme sensiblement plane. De préférence, la gaine comporte en outre des moyens de maintien de la nappe en position enroulée. Ces moyens de maintien peuvent être liés à la gaine, ou constituer une ou plusieurs pièce(s) distincte(s) de la gaine. Les moyens de maintien peuvent consister en un organe continu ou en une série d'organes distincts. Ils peuvent être disposés le long d'une génératrice de la gaine, ou de façon périphérique à la gaine. La nappe, une fois enroulée, peut posséder des bords en regard sensiblement adjacents, ou être agencée de façon à créer un certain recouvrement sur elle-même, ou être enroulée sur plusieurs tours.

Selon un autre mode de réalisation, la nappe initialement sensiblement plane est formée, par exemple thermoformée, sous une forme pré enroulée ayant un diamètre à l'état non contraint, et qui, lors de la mise en place autour d'un câble, peut être élastiquement déformée par augmentation de son diamètre et revenir élastiquement, par diminution de son diamètre, à une position d'utilisation. En d'autres termes, un utilisateur va agrandir la gaine, la mettre en place puis la relâcher autour du câble, la gaine se ré-enroulant alors automatiquement. En position d'utilisation, la gaine peut avoir un diamètre supérieur au diamètre qu'elle présente à l'état non contraint, assurant ainsi un certain serrage du câble, ou un diamètre voisin du diamètre du câble avec peu voire pas de serrage.

La nappe peut être configurée pour être enroulée autour d'un axe sensiblement parallèle à l'axe longitudinal de la nappe. En d'autres termes, la nappe est enroulée autour du câble, autour de l'axe du câble, comme une cigarette. Pour ce mode de réalisation, de préférence, la nappe présente une largeur - perpendiculairement à l'axe longitudinal - qui est au moins égale au périmètre du câble.

En variante, la nappe peut former un ruban qui est configuré pour être enroulé autour du câble en formant des spires jointives ou avec un recouvrement, de sorte que l'axe longitudinal de la nappe forme une hélice. Ce mode de réalisation est particulièrement intéressant pour un câble de gros diamètre, qui, avec une nappe enroulée comme une cigarette, nécessiterait une gaine de grande largeur. En pratique, avec ce mode de réalisation, la nappe présente par exemple une largeur de l'ordre de 25 à 50 mm.

Selon une réalisation possible, les éléments allongés du premier type et les éléments allongés du deuxième type sont assemblés l'un à l'autre dans une même couche de la gaine.

Selon une autre réalisation possible, les éléments allongés du premier type sont situés dans une première couche de la gaine et les éléments allongés du deuxième type sont situés dans une deuxième couche de la gaine, distincte de la première couche, coaxiale à la première couche, et de préférence située à l'intérieur de la première couche. Les éléments allongés situés dans une même couche peuvent être assemblés entre eux de façon entrecroisée et/ou être enroulés autour du câble. Par exemple, la couche externe est fabriquée sur la couche interne, de sorte que la couche interne sert de support à la couche externe, de sorte aussi que la couche externe bloque la couche interne. Les deux couches sont ainsi liées et tenues par les tensions des matériaux qui s'opposent lors de la production.

La gaine peut de plus comprendre des éléments allongés réalisés en un matériau polymère. Ceux-ci peuvent être assemblés aux éléments allongés du premier et/ou du deuxième type par entrecroisement dans une même couche de la gaine, ou être situés dans une couche additionnelle distincte de la gaine. Ces éléments allongés en polymère peuvent être des fils, des feuillards, etc. Ils peuvent être assemblés selon l'une des manières exposées précédemment. Ces éléments allongés en polymère apportent un renfort mécanique à la gaine.

La gaine peut en outre comporter une couche extérieure en textile configurée pour conférer une protection mécanique et une isolation électrique. Cette couche textile est de préférence mise en place dans un second temps, autour des éléments allongés du premier et du deuxième types.

La gaine comporte des connecteurs réalisés en un matériau électriquement conducteur et assemblés à l'enveloppe tubulaire flexible formée par les éléments allongés. Il peut notamment s'agir d'une cosse à œillet, ceci n'étant pas limitatif. Les connecteurs peuvent en outre présenter des propriétés magnétiques (et à cet effet contenir du fer et/ou du nickel). La gaine peut ainsi comprendre un connecteur d'extrémité, à chacune des extrémités longitudinales de l'enveloppe tubulaire flexible, et/ou au moins un connecteur intermédiaire, situé à distance de chacune des extrémités longitudinales de l'enveloppe tubulaire flexible. Selon un mode de réalisation ne faisant pas partie de l'invention, la gaine est réalisée sous la forme d'un tube fermé dans lequel on peut insérer un câble.

La gaine presente au moins un orifice, distinct des extrémités axiales de la gaine, configuré pour permettre le passage du câble. Si la gaine est formée d'une nappe enroulée, cet orifice peut être formé par un écartement localisé des bords en regard de la nappe. De préférence, la gaine présente deux tels orifices : ainsi, une partie centrale du câble peut être logée dans la gaine, tandis que les parties extrêmes du câble peuvent être situées à l'extérieur de la gaine et électriquement raccordées à l'organe ou l'équipement approprié.

Selon un deuxième aspect, l'invention concerne un ensemble comprenant une gaine telle que précédemment décrite et un câble au moins en partie logé dans la gaine.

Selon une réalisation possible, le diamètre intérieur de la gaine est sensiblement égal au diamètre extérieur du câble. On entend par là que le diamètre intérieur de la gaine est au plus égal à 1,1 fois le diamètre extérieur du câble.

Afin d'améliorer l'efficacité du blindage, on peut prévoir que la section - plus précisément la section métallique conductrice - de la gaine soit supérieure à 1/10^{ème}, de préférence supérieure à 1/5^{ème}, mieux encore supérieure à 1/3, de la section du câble - plus précisément la section de conduction du câble.

Selon un troisième aspect, l'invention concerne une installation comprenant un châssis métallique, un générateur de courant comportant une borne positive et une borne négative, un équipement, tel qu'un moteur électrique, électriquement connecté au châssis, et un ensemble tel que précédemment décrit. En outre, dans cette installation, la gaine comporte un connecteur en un matériau électriquement conducteur assemblé à chacune des extrémités de l'enveloppe tubulaire flexible formée par les éléments allongés, l'un des connecteurs étant relié à la borne négative du générateur et l'autre au châssis, la gaine comportant un premier et un deuxième orifices distincts des extrémités de l'enveloppe tubulaire flexible. De plus, le câble possède une partie centrale logée dans la gaine entre les deux orifices de celle-ci, et passe par les orifices de sorte à présenter deux parties extrêmes situées à l'extérieur de la gaine, une partie extrême étant électriquement connectée à la borne positive du générateur et l'autre partie extrême étant électriquement connectée à l'équipement de l'installation, le câble étant de préférence disposé de façon sensiblement adjacente au châssis, au moins dans sa partie centrale.

Une telle installation peut être un véhicule, en particulier un véhicule hybride.

On décrit à présent, à titre d'exemples non limitatifs, plusieurs modes de réalisation possibles de l'invention, en référence aux figures annexées :
La figure 1 est une vue schématique en perspective d'un habitacle de véhicule comprenant un câble en partie logé dans une gaine de blindage magnétique selon l'invention ;
La figure 2 est une vue agrandie du détail A de la figure 1 ;
La figure 3 est une vue agrandie du détail B de la figure 1 ;
La figure 4 est une vue schématique de la section d'une gaine selon un mode de réalisation ne faisant partie de l'invention ;
La figure 5 est une vue schématique de la section d'une gaine selon un autre mode ne faisant partie de réalisation de l'invention ;
La figure 6 est une vue schématique d'un mode d'assemblage d'éléments allongés dans la gaine ;
La figure 7 est une vue schématique d'un autre mode d'assemblage d'éléments allongés dans la gaine ;
La figure 8 est une vue schématique d'un mode d'assemblage d'éléments allongés de la gaine autour du câble ;
La figure 9 est une vue schématique d'un autre mode d'assemblage d'éléments allongés de la gaine autour du câble ;
La figure 10 représente un câble et une gaine mise en place autour du câble selon un mode de réalisation ;
La figure 11 représente un câble et une gaine mise en place autour du câble selon un autre mode de réalisation ;
La figure 12 représente un câble et une gaine mise en place autour du câble selon encore un autre mode de réalisation ;
La figure 13 est une vue similaire à la figure 12, montrant une partie extrême du câble sortant de la gaine ;
La figure 14 représente un câble et une gaine mise en place autour du câble selon encore un autre mode de réalisation ;
La figure 15 est une vue similaire à la figure 14, montrant une partie extrême du câble sortant de la gaine ;
La figure 16 illustre une variante de réalisation d'une gaine selon l'invention, mise en place autour d'un câble.

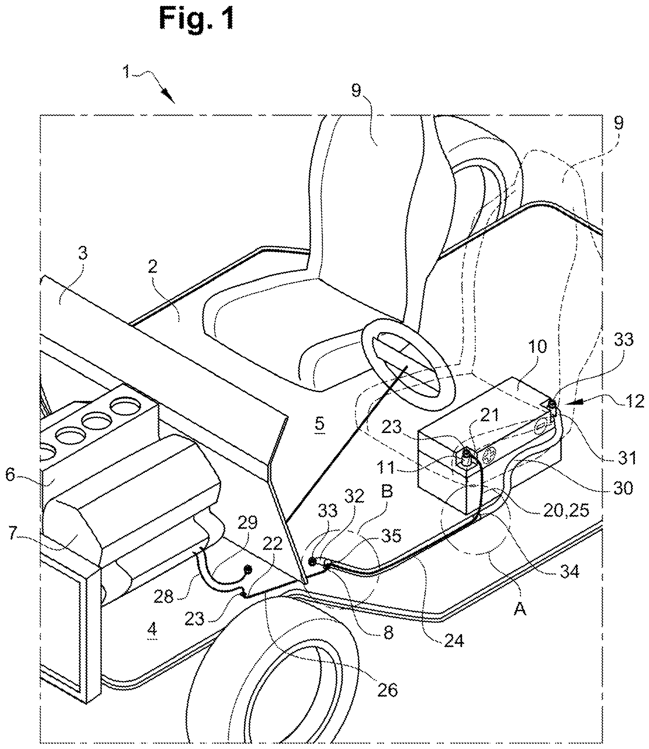

La figure 1 représente schématiquement et partiellement un véhicule 1.

Le véhicule 1 comporte un châssis 2 qui est généralement formé de l'assemblage, notamment par soudage, de plusieurs pièces pouvant être réalisées en des métaux différents, plus ou moins bons conducteurs de l'électricité. Outre ces pièces métalliques, le châssis 2 peut également comporter des parties non métalliques, par exemple en fibres de carbone. Le châssis 2 présente des zones de soudure, ainsi que des perforations ou des fentes, pour répondre aux différents besoins d'ancrage et de traversées de cloisons du véhicule 1. Le châssis 2 forme un plan de masse pour le véhicule 1, et il découle de ce qui précède que ce plan de masse est hétérogène.

Comme on le voit sur la figure 1, une cloison 3 fixée au châssis 2 sépare un compartiment moteur 4, à l'avant du véhicule 1, d'un habitacle 5 où s'installeront le conducteur et les éventuels passagers.

Dans le cas d'un véhicule hybride, le compartiment moteur 4 comporte un moteur thermique 6 et un moteur électrique 7. Un générateur 10 permet d'alimenter le moteur électrique 7. Ce générateur 10, typiquement une batterie, peut être installé dans l'habitacle 5, sous un siège 9. Le générateur 10 comporte une borne positive 11 et une borne négative 12.

Le moteur électrique 7 est alimenté par le générateur 10 par un circuit électrique qui comporte un câble 20 formant le conducteur électrique aller et une gaine 30 formant le conducteur électrique retour.

Le câble 20 possède une première extrémité 21, de préférence munie d'un connecteur 23, électriquement connectée à la borne positive 11, et une deuxième extrémité 22, de préférence munie d'un connecteur 23, électriquement connectée au moteur électrique 7 (ou à un conducteur 28 lui-même connecté au moteur électrique 7).

La gaine 30 forme une enveloppe tubulaire flexible qui loge en partie le câble 20, et qui présente une première extrémité 31 électriquement connectée à la borne négative 12 du générateur 10 et une deuxième extrémité 32 électriquement connectée au châssis 2. De préférence, un connecteur 33 est assemblé à chacune des extrémités 31, 32 de ladite enveloppe de la gaine 30.

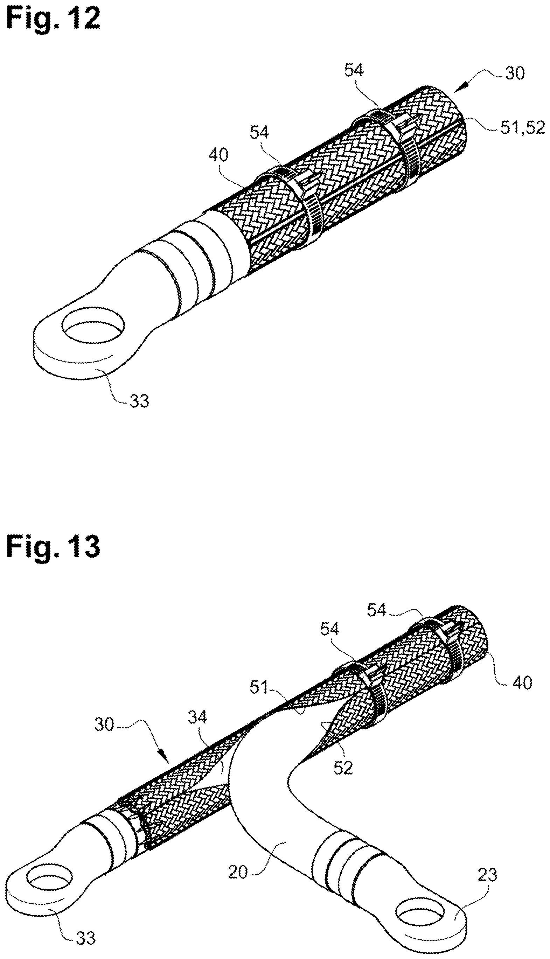

Les connecteurs d'extrémité 23, 33 sont réalisés en un matériau électriquement conducteur, qui peut en outre présenter des propriétés magnétiques favorable à l'effet de blindage. Il peut s'agir de cosses à œillet, comme illustré par exemple sur les figures 1 et 12, vissées sur la borne 11, 12 ou le châssis 2. D'autres variantes de réalisation de tels connecteurs sont possibles. Notamment, le connecteur pourrait être formé d'une plaque, par exemple obtenue par l'aplatissement d'un tube, soudée ou autrement mécaniquement et électriquement reliée au câble 20 ou à la gaine 30.

Dans la réalisation représentée sur les figures 1 à 3, la gaine 30 comporte un premier orifice 34 et un deuxième orifice 35 distincts des extrémités 31, 32 de l'enveloppe tubulaire flexible, et espacés l'un de l'autre. Le câble 20 possède une partie centrale 24 logée dans la gaine 30 entre les deux orifices 34, 35 de celle-ci, et passe par les orifices 34, 35, le câble 20 présentant ainsi deux parties extrêmes situées à l'extérieur de la gaine 30. Plus spécifiquement, le câble 20 peut présenter une première partie extrême 25 entre la première extrémité 21 du câble 20 et la partie centrale 24 du câble 20, qui, en position montée, s'étend de la borne positive 11 du générateur 10 à l'orifice 34 de la gaine 30 ; et une deuxième partie extrême entre la deuxième extrémité 22 du câble 20 et la partie centrale 24 du câble 20, qui, en position montée, s'étend de l'orifice 35 au conducteur connecté au moteur électrique 7.

La gaine 30 vise à assurer un blindage magnétique du câble 20, c'est-à-dire à former une barrière au champ magnétique émis par le câble 20, lorsqu'il est parcouru par un courant, afin de protéger les équipements et personnes dans l'environnement du câble 20. Il est donc préférable que le câble 20 soit en grande partie logé dans la gaine 30, au moins dans un espace où se situent des équipements ou des personnes à protéger.

A titre d'exemple, et selon les implantations et les applications, la partie centrale 24 du câble 20, logée dans la gaine 30, peut avoir une longueur d'au moins la moitié, voire au moins les deux tiers, de la longueur totale du câble 20. Cette partie centrale 24 du câble 20 correspond de préférence à la partie du câble située dans l'habitacle 5 du véhicule 1.

Comme on le voit sur les figures 1 à 3, le câble 20 est de préférence disposé de façon sensiblement adjacente au châssis 2, au moins dans sa partie centrale 24. L'orifice 34 peut se situer en partie supérieure de la gaine 30, pour simplifier le trajet de la première partie extrême 25 du câble 20 vers la borne positive 11 du générateur 10. Par ailleurs, l'orifice 35 peut se situer en partie inférieure de la gaine 30 et en regard d'un orifice 8 ménagé dans le châssis 2. Le câble 20 peut ainsi sortir par l'orifice 35 de la gaine 30 et par l'orifice 8 du châssis 2, pour passer de l'intérieur de l'habitacle 5 à la zone située sous le châssis 2, d'un côté à l'autre de la cloison 3, jusqu'au compartiment moteur 4.

La deuxième extrémité 32 de la gaine 30 peut être située dans l'habitacle 5, la liaison avec le moteur électrique 7 s'effectuant via le châssis 2 et un conducteur 29 connecté d'une part au moteur électrique 7 et d'autre part au châssis 2, généralement dans le compartiment moteur 4.

Le fait de placer le câble 20, dans la gaine 30, au voisinage du châssis 2, peut résulter de contrainte d'espace disponible dans l'habitacle 5. Cette disposition est avantageuse en ce qu'elle permet de diminuer la surface de boucle (c'est-à-dire la surface entre le câble 20 et le plan de masse). En revanche, la proximité d'un châssis 2 hétérogène tendant à dégrader l'efficacité du blindage, il est important que l'invention fournisse une gaine ayant des capacités magnétiques suffisantes.

La gaine 30 comporte ou est formé d'un assemblage d'éléments allongés 40 qui peuvent être des fils, en particulier des fils de section ronde ou des fils méplats, des feuillards, notamment des feuillards laminés, ou analogue.

La gaine 30 comporte :
- d'une part des éléments allongés 41 d'un premier type qui sont réalisés en au moins un matériau électriquement conducteur, afin d'assurer le retour du courant par la gaine 30 depuis le moteur électrique 7 jusqu'à la borne négative 12 du générateur 10 ;
- et d'autre part des éléments allongés 42 d'un deuxième type, différent du premier type, réalisés en au moins un matériau ayant des propriétés magnétiques suffisantes pour produire l'effet de blindage.

Les éléments allongés 41 du premier type peuvent être réalisés en au moins un matériau possédant une conductivité électrique relative σr supérieure à 0,5, de préférence supérieure à 0,6, à température ambiante. Ces éléments allongés 41 peuvent comprendre ou être réalisés en cuivre ou en aluminium.

Les éléments allongés 42 du deuxième type peuvent être réalisés en au moins un matériau possédant une perméabilité magnétique relative µr qui, à température ambiante, et dans une gamme de fréquences comprises entre 0 Hz et 500 kHz, peut être comprise entre 50 et 7000. De préférence, cette perméabilité magnétique relative µr peut être supérieure à 100, mieux encore 200, voire 500. De préférence, cette perméabilité magnétique relative µr peut être inférieure à 6000, mieux encore 5500, voire 1000. Ces éléments allongés 42 peuvent comprendre ou être réalisés en fer, nickel, cobalt, ou un alliage comportant au moins l'un de ces métaux. De préférence, il ne s'agit ni de mumétal ni de permalloy.

En pratique, on peut déterminer la gamme de fréquences du champ magnétique perturbateur, et en déduire le matériau le plus adapté, c'est-à-dire généralement celui ayant la plus grande perméabilité magnétique relative dans cette gamme.

L'assemblage des éléments allongés 40, 41, 42 dans la gaine 30 est obtenu par entrecroisement et/ou enlacement.

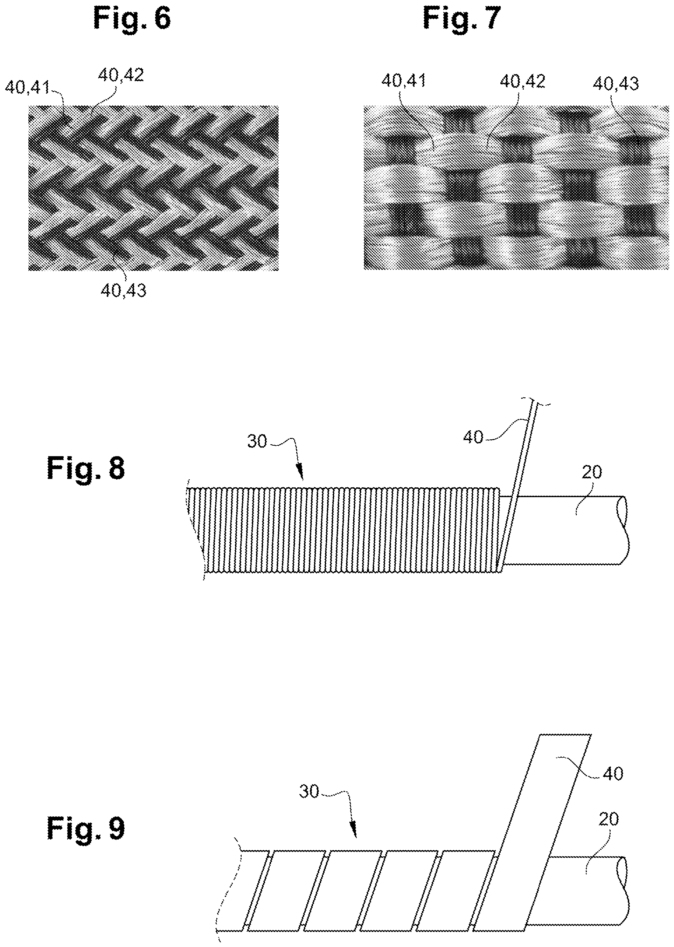

Ainsi, les éléments allongés 40 peuvent être assemblés par tressage (la figure 6 illustrant un exemple de tressage), par tissage (la figure 7 illustrant un exemple de tissage). Les éléments allongés 40 peuvent par ailleurs être assemblés par enroulement à spires jointives (comme illustré sur la figure 8) ou par enrubannage (comme illustré sur la figure 9). D'autres modes d'assemblage peuvent être utilisés, comme le tricotage et le guipage.

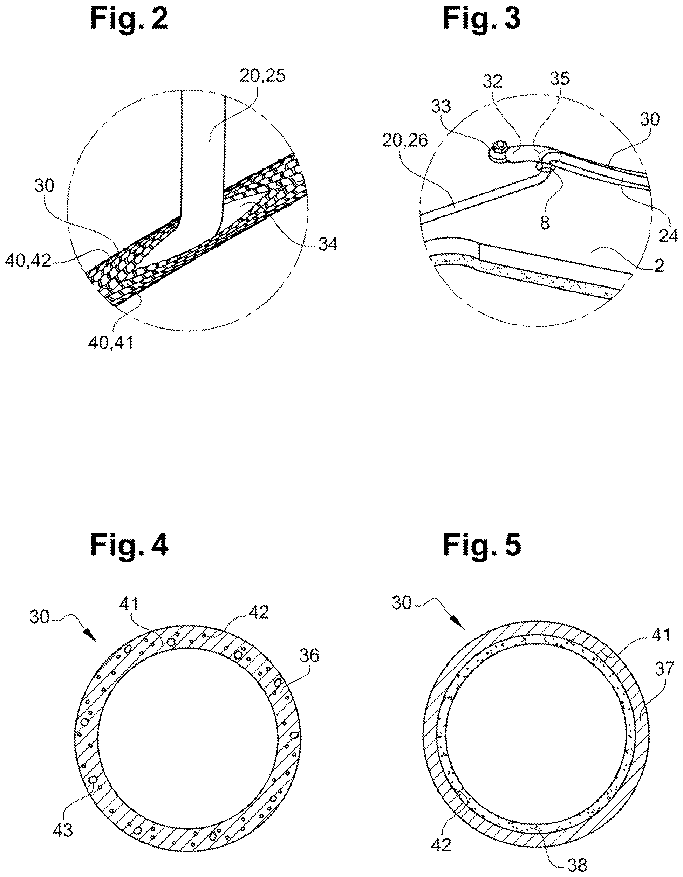

Selon un mode de réalisation, comme illustré schématiquement sur la figure 4, les éléments allongés 41 du premier type et les éléments allongés du deuxième type 42 sont assemblés l'un à l'autre dans une même couche 36 de la gaine 30.

Selon un autre mode de réalisation, comme illustré schématiquement sur la figure 5, les éléments allongés 41 du premier type sont situés dans une première couche 37 de la gaine 30, tandis que les éléments allongés 42 du deuxième type sont situés dans une deuxième couche 38 de la gaine 30, distincte de la première couche 37, et coaxiale à la première couche 37. Afin d'améliorer l'efficacité de blindage, il est préférable que la couche magnétique, c'est-à-dire ici la deuxième couche 38 incluant les éléments allongés 42 du deuxième type, soit située au plus près du câble, donc à l'intérieur de la première couche 37.

En outre, toujours dans le but d'améliorer l'efficacité de blindage, le diamètre intérieur de la gaine 30 peut être sensiblement égal au diamètre extérieur du câble 20, de sorte que les éléments allongés 42 du deuxième type soient situés au plus près du câble 20.

On peut obtenir un blindage suffisant en prévoyant une section métallique conductrice de la gaine 30 supérieure à 1/10^{ème} de la section de conduction du câble 20. En choisissant une section de la gaine 30 supérieure à 1/3 de la section du câble 20, le blindage s'avère très efficace. Par exemple, pour un câble 20 de section égale à 70 mm², on pourra opter pour une gaine 30 dont la section (c'est-à-dire la surface transversale en forme d'anneau) est de 25 mm². Pour une efficacité encore accrue, on peut prévoir que la section de la gaine 30 soit supérieure à la moitié de la section du câble 20, ce qui, pour un câble 20 de section égale à 70 mm², conduirait à une gaine 30 de section d'au moins 35 mm².

La gaine 30 peut en outre comporter des éléments allongés 43 réalisés en un matériau polymère, tels que des fibres multifilamentaires ou monofilamentaires, comme illustré schématiquement sur la figure 4. Ces éléments allongés 43 en polymère peuvent être assemblés aux éléments allongés 41, 42 du premier et/ou du deuxième type par entrecroisement dans une même couche 36 de la gaine 30, ou être situés dans une couche additionnelle distincte de la gaine 30 (ce mode de réalisation n'étant pas représenté). De tels éléments allongés 43 en polymère peuvent apporter un renfort mécanique, ce qui peut s'avérer important lorsque les éléments allongés 41, 42 du premier et/ou du deuxième type sont des fils très fins (par exemple de 0,03 à 0,20 mm).

A titre d'exemple, comme illustré sur la figure 6, respectivement la figure 7, on peut avoir un tressage, respectivement un tissage entre :
- une première sorte de brins comprenant des éléments allongés 41 du premier type et des éléments allongés 42 du deuxième type ;
- et une deuxième sorte de brins comprenant des éléments allongés 43 réalisés en un matériau polymère.

D'autres assemblage des éléments allongés entre eux sont toutefois envisageable. En particulier, le ou les types des éléments allongés contenus dans une sorte donnée de brin pourrait être différent(s).

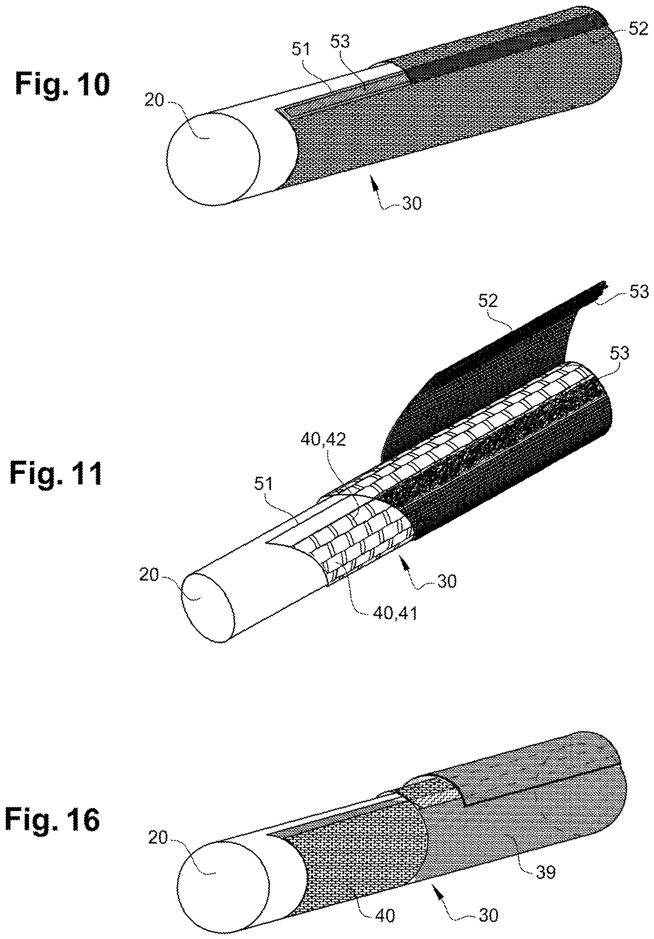

Par ailleurs, la gaine 30 peut également comprendre une couche extérieure 39 en textile (un exemple de réalisation étant illustré sur la figure 16). Une telle couche textile permet de conférer une protection mécanique et une isolation électrique.

On s'intéresse à présent aux différentes configurations que peut présenter la gaine 30.

Selon un mode de réalisation, comme illustré sur les figures 4 et 5, la gaine 30 est réalisée sous la forme d'un tube fermé dans lequel on peut insérer le câble 20, le tube étant obtenu à partir d'une nappe initialement sensiblement plane. Une fois le câble 20 inséré, les connecteurs 33 peuvent être mis en place.

Sur la figure 8, les éléments allongés 40 sont enroulés autour du câble 20.

Selon un autre mode de réalisation, la gaine 30 est réalisée sous la forme d'une nappe initialement sensiblement plane, apte à être enroulée autour du câble 20. La nappe peut être tissée, tressée, tricotée, etc. La nappe peut être fabriquée à plat, ou résulter d'un aplatissage par laminage d'une structure tubulaire.

Sur la figure 9, la nappe présente la forme d'un ruban, c'est-à-dire avec une largeur nettement plus faible que sa longueur. La nappe est enroulée autour du câble 20 en formant des spires jointives ou avec un recouvrement.

En variante, la nappe comporte deux bords libres 51, 52 qui, en position montée de la gaine 30, pourront être disposés sensiblement longitudinalement, c'est-à-dire selon l'axe du câble 20 et de la gaine 30. En position montée, les bords libres 51, 52 peuvent être disposés bord à bord ou, en variante, la nappe peut être enroulée sur plus d'un tour et présenter ainsi un recouvrement. En outre, de préférence, des moyens de maintien sont prévus pour maintenir la nappe en position enroulée autour du câble 20.

Sur la figure 10, la nappe est enroulée sur un peu plus d'un tour, de sorte qu'il y ait un recouvrement entre les bandes extrêmes de la nappe situées chacune le long de l'un des bords libres 51, 52. Les moyens de maintien sont constitués par des moyens auto agrippants 53, tels qu'une pièce portant des boucles et une pièce portant des crochets d'un système velcro^{®}, ces pièces étant fixées (par exemple cousues) sur la nappe à proximité des bords libres 51, 52, dans la zone de recouvrement. D'autres moyens de maintien pourraient être prévus en variante, tels que boutons pressions, rivets, fermeture à glissière, etc.

Sur la figure 11, la nappe est enroulée en plusieurs tours autour du câble 20, puis attachée par des moyens auto agrippants 53, par exemple, pour former la gaine 30.

Sur la figure 12, les moyens de maintien sont formés par un ou plusieurs liens 54 entourant la gaine 30 et la serrant autour du câble 20. Il peut par exemple s'agir de colliers de ligature en métal ou en plastique. Les bords libres 51, 52 de la nappe peuvent être sensiblement en regard et jointifs, ou il peut y avoir un certain recouvrement comme à la figure 10. La figure 13 illustre comment, en écartant localement les bords libres 51, 52 de la nappe, on crée dans la gaine 30 un orifice 34 pour le passage du câble 20.

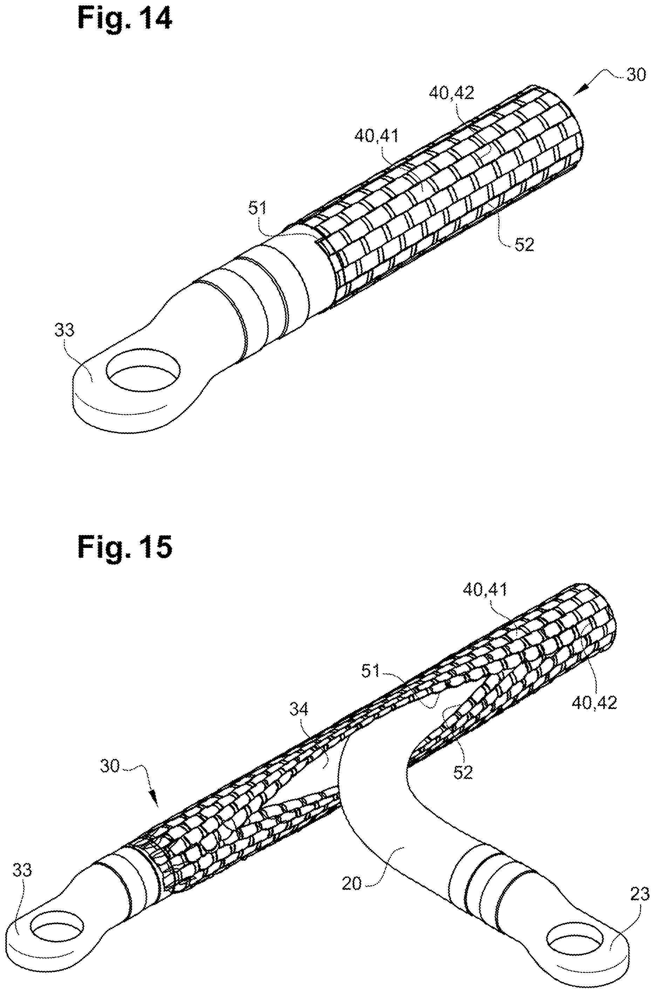

Selon encore un autre mode de réalisation, illustré sur les figures 14 et 15, la gaine 30 est réalisée sous la forme d'une nappe initialement sensiblement plane qui est formée, par exemple thermoformée, sous une forme pré enroulée ayant un certain diamètre à l'état non contraint. Lors de la mise en place autour d'un câble, on déforme élastiquement cette nappe pré enroule, de sorte à augmenter son diamètre, puis on la place autour du câble 20. Lorsqu'on relâche la nappe, celle-ci revient élastiquement vers sa position à l'état non contraint, mais pas nécessairement jusqu'à cette position, par diminution de son diamètre. Ainsi, en position d'utilisation, la nappe forme une gaine 30 entourant le câble, éventuellement avec un certain serrage. Cette configuration de la gaine 30 est intéressante de par la facilité de mise en œuvre.

De façon similaire à la réalisation de la figure 13, la figure 15 montre la création d'un orifice 34 de passage du câble 20 par écartement localisé des bords libres 51, 52 de la nappe qui forme la gaine 30.

Enfin, la figure 16 montre une gaine 30 comprenant une couche 38 comportant les éléments allongés 41, 42 du premier et du deuxième type, cette couche pouvant prendre l'une quelconque des formes décrites précédemment, ainsi qu'une couche extérieure 39 en textile. Dans la réalisation représentée, la couche extérieure 39 en textile peut être réalisée sous la forme d'une nappe initialement sensiblement plane, et être enroulée autour du câble 20 et maintenue par des moyens de maintien appropriés. Ces moyens de maintien sont représentés sous forme de moyens auto agrippants 53, mais ceci ne doit pas être considéré comme limitatif.

Il va de soi que l'invention n'est pas limitée aux modes de réalisation décrits ci-dessus à titre d'exemples mais qu'elle comprend tous les équivalents techniques et les variantes des moyens décrits ainsi que leurs combinaisons.

En particulier, bien que l'invention ait été décrite dans le cadre d'un véhicule hybride, elle peut s'appliquer à une installation autre qu'un véhicule, avec un équipement autre qu'un moteur électrique, pour le blindage magnétique d'un câble.

## Revendications

1. Gaine (30) de blindage magnétique pour un câble (20) électrique, la gaine (30) présentant la forme d'une nappe initialement sensiblement plane, enroulée sur elle-même pour former une enveloppe tubulaire flexible configurée pour recevoir le câble (20), la gaine (30) comprenant des éléments allongés (40, 41, 42, 43), tels que des fils ou des feuillards, qui sont assemblés de façon entrecroisée et/ou en formant un enlacement, **caractérisé en ce que** lesdits éléments allongés (40, 41, 42, 43) comportent :
- des éléments allongés (41) d'un premier type, réalisés en au moins un matériau électriquement conducteur, configurés pour former un conducteur apte à acheminer un courant de retour d'un courant circulant dans le câble logé dans la gaine, le courant de retour créant un champ magnétique opposé à un champ magnétique perturbateur créé par le courant circulant dans le câble;
- des éléments allongés (42) d'un deuxième type, différent du premier type, réalisés en au moins un matériau possédant une perméabilité magnétique relative µr comprise entre µr min et µr max, où, à température ambiante, et dans une gamme de fréquences comprises entre 0 Hz et 500 kHz :
- µr min vaut 50, de préférence 100, mieux encore 200, voire 500 ;
- µr max vaut 7000, de préférence 6000, mieux encore 5500, voire 1000.
les éléments allongés (42) du deuxième type étant ainsi configurés pour produire un effet de blindage contre le champ magnétique résultant de la somme du champ perturbateur et du champ créé par le courant de retour ;
la gaine étant en outre **caractérisée en ce qu'**elle comporte des connecteurs d'extrémité (33) réalisés en un matériau électriquement conducteur et assemblés à l'enveloppe tubulaire flexible formée par les éléments allongés (40), et au moins un orifice (34, 35), distinct des extrémités axiales de la gaine (30), configuré pour permettre le passage du câble (20).

2. Gaine selon la revendication 1, **caractérisée en ce que** les éléments allongés (41) du premier type sont réalisés en au moins un matériau possédant une conductivité électrique relative σr supérieure à 0,5, de préférence supérieure à 0,6, à température ambiante, ledit matériau étant par exemple le cuivre ou l'aluminium, la conductivité électrique relative σr d'un matériau étant un nombre sans dimension défini comme la conductivité électrique du matériau divisée par la conductivité électrique du cuivre.

3. Gaine selon l'une des revendications 1 à 2, **caractérisée en ce que** les éléments allongés (42) du deuxième type sont réalisés en un matériau appartenant au groupe formé par : le fer, le nickel, le cobalt et leurs alliages.

4. Gaine selon l'une des revendications 1 à 3, **caractérisée en ce que** les éléments allongés (40) appartiennent au groupe comprenant : les fils de section ronde, les fils méplats, les feuillards, notamment les feuillards laminés.

5. Gaine selon l'une des revendications 1 à 4, **caractérisée en ce que**, dans la nappe, les éléments allongés (40) sont assemblés par tressage, tricotage, tissage, et/ou guipage.

6. Gaine selon l'une des revendications 1 à 5, **caractérisée en ce que** la nappe est configurée pour être enroulée autour du câble (20) en partant d'une forme sensiblement plane, et **en ce que**, de préférence, elle comporte en outre des moyens de maintien (53, 54) de la nappe en position enroulée.

7. Gaine selon l'une des revendications 1 à 5, **caractérisée en ce que** la nappe initialement sensiblement plane est formée, par exemple thermoformée, sous une forme pré enroulée ayant un diamètre à l'état non contraint, ladite nappe étant élastiquement déformable de sorte que, lors de la mise en place de la nappe autour d'un câble (20), ladite nappe peut être élastiquement déformée par augmentation de son diamètre et revenir élastiquement, par diminution de son diamètre, à une position d'utilisation.

8. Gaine selon l'une des revendications 1 à 7, **caractérisée en ce que** les éléments allongés (41) du premier type et les éléments allongés (42) du deuxième type sont assemblés l'un à l'autre dans une même couche (36) de la gaine (30).

9. Gaine selon l'une des revendications 1 à 7, **caractérisée en ce que** les éléments allongés (41) du premier type sont situés dans une première couche (37) de la gaine (30) et **en ce que** les éléments allongés (42) du deuxième type sont situés dans une deuxième couche (38) de la gaine (30), distincte de la première couche (37), coaxiale à la première couche (37), et de préférence située à l'intérieur de la première couche (37).

10. Gaine selon l'une des revendications 1 à 9, **caractérisée en ce qu'**elle comporte en outre une couche extérieure (39) en textile configurée pour conférer une protection mécanique et une isolation électrique.

11. Ensemble comprenant une gaine (30) selon l'une des revendications 1 à 10 et un câble (20) au moins en partie logé dans la gaine (30), **caractérisé en ce que** le diamètre intérieur de la gaine (30) est sensiblement égal au diamètre extérieur du câble (20).

12. Ensemble comprenant une gaine (30) selon l'une des revendications 1 à 10 et un câble (20) au moins en partie logé dans la gaine (30), **caractérisé en ce que** la section de la gaine (30) est supérieure à 1/10ème, de préférence supérieure à 1/5ème, mieux encore supérieure à 1/3, de la section du câble (20).

13. Installation, telle qu'un véhicule (1), en particulier un véhicule hybride, l'installation comprenant :
- un châssis (2) métallique ;
- un générateur (10) de courant comportant une borne positive (11) et une borne négative (12) ;
- un équipement (7), tel qu'un moteur électrique, électriquement connecté au châssis (2) ;
- un ensemble selon la revendication 11 ou 12 ;
dans laquelle :
- la gaine (30) comporte un connecteur (33) en un matériau électriquement conducteur assemblé à chacune des extrémités de l'enveloppe tubulaire flexible formée par les éléments allongés (40), l'un des connecteurs (33) étant relié à la borne négative (12) du générateur (10) et l'autre au châssis (2), la gaine (30) comportant un premier et un deuxième orifices 34, 35) distincts des extrémités de l'enveloppe tubulaire flexible ;
- le câble (20) possède une partie centrale (24) logée dans la gaine (30) entre les deux orifices (34, 35) de celle-ci, et passe par les orifices (34, 35) de sorte à présenter deux parties extrêmes (25, 26) situées à l'extérieur de la gaine (30), une partie extrême (25) étant électriquement connectée à la borne positive (11) du générateur (10) et l'autre partie extrême (26) étant électriquement connectée à l'équipement (7) de l'installation (1), le câble (20) étant de préférence disposé de façon sensiblement adjacente au châssis (2), au moins dans sa partie centrale (24).

## Patentansprüche

1. Magnetische Schirmhülle (30) für ein elektrisches Kabel (20), wobei die Hülle (30) die Form einer anfänglich im Wesentlichen flachen Bahn aufweist, die um sich selbst gewickelt ist, um eine flexible Rohrhülle zu bilden, die zur Aufnahme des Kabels (20) eingerichtet ist, wobei die Hülle (30) längliche Elemente (40, 41, 42, 43) umfasst, wie Drähte oder Bänder, die kreuzweise und/oder bindend verbunden sind, **dadurch gekennzeichnet, dass** die länglichen Elemente (40, 41, 42, 43) Folgendes beinhalten:
- längliche Elemente (41) eines ersten Typs, die aus mindestens einem elektrisch leitenden Material hergestellt sind, die so eingerichtet sind, dass sie einen Leiter bilden, der in der Lage ist, einen Rückstrom eines im Kabel in der Hülle fließenden Stroms zu leiten, wobei der Rückstrom ein Magnetfeld erzeugt, das einem störenden Magnetfeld entgegensteht, das durch den im Kabel fließenden Strom erzeugt wird;
- längliche Elemente (42) eines zweiten Typs, die sich vom ersten Typ unterscheiden, aus mindestens einem Material mit einer relativen magnetischen Durchlässigkeit µr zwischen µr min und µr max, wobei bei Raumtemperatur und in einem Frequenzbereich zwischen 0 Hz und 500 kHz:
- µr min 50, vorzugsweise 100, besser noch 200 oder sogar 500 ist;
- µr max 7000, vorzugsweise 6000, besser noch 5500 oder sogar 1000 ist;
die länglichen Elemente (42) des zweiten Typs so eingerichtet sind, dass sie einen Schirmeffekt gegen das Magnetfeld erzeugen, der sich aus der Summe des Störfelds und dem durch den Rückstrom erzeugten Feld ergibt;
wobei die Hülle ferner **dadurch gekennzeichnet ist, dass** sie Endverbinder (33) aus einem elektrisch leitenden Material beinhaltet, die mit der flexiblen Rohrhülle verbunden sind, die von den verlängerten Elementen (40) gebildet wird, und mindestens eine Öffnung (34, 35), die von den axialen Enden der Hülle (30) getrennt ist, die so eingerichtet ist, dass sie die Durchführung des Kabels (20) ermöglicht.

2. Mantel nach Anspruch 1, **dadurch gekennzeichnet, dass** die länglichen Elemente (41) des ersten Typs aus mindestens einem Material mit einer relativen elektrischen Leitfähigkeit Gold von mehr als 0,5, vorzugsweise mehr als 0,6, bei Raumtemperatur hergestellt sind, wobei das Material beispielsweise Kupfer oder Aluminium ist, wobei die relative elektrische Gold-Leitfähigkeit eines Materials eine maßlose Zahl ist, die als elektrische Leitfähigkeit des Materials geteilt durch die elektrische Leitfähigkeit des Kupfers definiert ist.

3. Hülle nach einem der Ansprüche 1 bis 2, **dadurch gekennzeichnet, dass** die länglichen Elemente (42) des zweiten Typs aus einem Material gefertigt sind, das zur Gruppe gehört, die gebildet wird aus: Eisen, Nickel, Kobalt und deren Legierungen.

4. Hülle nach einem der Ansprüche 1 bis 3, **dadurch gekennzeichnet, dass** die länglichen Elemente (40) zur Gruppe gehören, umfassend: Drähte mit rundem Querschnitt, Flachdrähte, Bänder, insbesondere gewalzte Bänder.

5. Hülle nach einem der Ansprüche 1 bis 4, **dadurch gekennzeichnet, dass** in der Bahn die länglichen Elemente (40) durch Flechten, Stricken, Weben und/oder Umwickeln verbunden sind.

6. Hülle nach einem der Ansprüche 1 bis 5, **dadurch gekennzeichnet, dass** die Bahn eingerichtet ist, um das Kabel (20) ausgehend von einer im Wesentlichen ebenen Form gewickelt zu werden, und dass sie vorzugsweise ferner Haltemittel (53, 54) für die Bahn in gewickelter Position beinhaltet.

7. Hülle nach einem der Ansprüche 1 bis 5, **dadurch gekennzeichnet, dass** die anfänglich im Wesentlichen ebene Bahn in einer vorgewickelten Form mit einem Durchmesser im ungespannten Zustand ausgebildet, beispielsweise thermogeformt, ist, wobei die Bahn elastisch verformbar ist, so dass beim Anbringen der Bahn um ein Kabel (20) die Bahn durch Zunahme ihres Durchmessers elastisch verformt und durch Verringerung seines Durchmessers elastisch in eine Gebrauchsposition zurückkehren kann.

8. Hülle nach einem der Ansprüche 1 bis 7, **dadurch gekennzeichnet, dass** die länglichen Elemente (41) des ersten Typs und die länglichen Elemente (42) des zweiten Typs in einer gleichen Schicht (36) der Hülle (30) miteinander verbunden sind.

9. Hülle nach einem der Ansprüche 1 bis 7, **dadurch gekennzeichnet, dass** die länglichen Elemente (41) des ersten Typs in einer ersten Schicht (37) der Hülle (30) und die länglichen Elemente (42) des zweiten Typs in einer zweiten Schicht (38) der Hülle (30) liegen, die von der ersten Schicht (37) getrennt, koaxial zur ersten Schicht (37) und vorzugsweise innerhalb der ersten Schicht (37) liegt.

10. Hülle nach einem der Ansprüche 1 bis 9, **dadurch gekennzeichnet, dass** sie ferner eine äußere Textilschicht (39) beinhaltet, die so eingerichtet ist, dass sie einen mechanischen Schutz und eine elektrische Isolierung bietet.

11. Baugruppe umfassend eine Hülle (30) nach einem der Ansprüche 1 bis 10 und einem Kabel (20), das mindestens teilweise in der Hülle (30) untergebracht ist, **dadurch gekennzeichnet, dass** der Innendurchmesser der Hülle (30) im Wesentlichen gleich dem Außendurchmesser des Kabels (20) ist.

12. Baugruppe umfassend eine Hülle (30) nach einem der Ansprüche 1 bis 10 und einem Kabel (20), das mindestens teilweise in der Hülle (30) untergebracht ist, **dadurch gekennzeichnet, dass** der Querschnitt der Hülle (30) größer als 1 Zehntel, vorzugsweise größer als 1 Fünftel, besser noch größer als 1 Drittel des Kabelquerschnitts (20) ist.

13. Anlage, wie ein Fahrzeug (1), insbesondere ein Hybridfahrzeug, die Anlage umfassend:
- ein Metallgestell (2);
- einen Stromgenerator (10) beinhaltend eine positive Klemme (11) und eine negative Klemme (12);
- eine Ausrüstung (7), wie ein Elektromotor, der elektrisch mit dem Gestell (2) verbunden ist;
- eine Baugruppe nach Anspruch 11 oder 12;
wobei:
- die Hülle (30) einen Steckverbinder (33) aus einem elektrisch leitenden Material beinhaltet, der an jedem der Enden der flexiblen Rohrhülle, die durch die verlängerten Elemente (40) gebildet wird, montiert ist, wobei einer der Steckverbinder (33) mit dem Minuspol (12) des Generators (10) und der andere mit dem Gestell (2) verbunden ist, wobei die Hülle (30) eine erste und eine zweite Öffnung (34, 35) beinhaltet, die von den Enden der flexiblen Rohrhülle getrennt sind,
- das Kabel (20) besitzt einen Mittelteil (24), der sich in der Hülle (30) zwischen den beiden Öffnungen (34, 35) der Hülle befindet, und verläuft durch die Öffnungen (34, 35), so dass zwei äußere Teile (25, 26) außerhalb der Hülle (30) vorhanden sind, wobei ein äußerer Teil (25) elektrisch mit dem Pluspol (11) des Generators (10) verbunden ist und der andere äußere Teil (26) elektrisch mit der Ausrüstung (7) der Anlage (1) verbunden ist, wobei das Kabel (20) vorzugsweise im Wesentlichen angrenzend zum Gestell (2), mindestens in dessen Mittelteil (24), angeordnet ist.

## Claims

1. A magnetic shielding sheath (30) for an electric cable (20), the sheath (30) having the form of an initially substantially flat sheet, wound on itself to form a flexible tubular casing configured to receive the cable (20), the sheath (30) comprising elongated elements (40, 41, 42, 43), such as wires or strips, which are assembled in a crisscross manner and/or forming an encircling, **characterized in that** the elongated elements (40, 41, 42, 43) include:
- elongated elements (41) of a first type, made of at least one electrically conductive material, configured to form a conductor able to carry out a return current of a carried out by the cable housed in the sheath, the return current creating a magnetic field opposite to a disturbing magnetic field created by the current flowing in the cable;
- elongated elements (42) of a second type, different from the first type, made of at least one material having a relative magnetic permeability µr of between µr min and µr max, where, at room temperature, and in a frequency range comprised between 0 Hz and 500 kHz:
- µr min is equal to 50, preferably 100, better still 200, or even 500;
- µr max is equal to 7000, preferably 6000, better still 5500, or even 1000;
the elongated elements (42) of the second type thus being configured to provide a shielding against the magnetic field resulting from the sum of the disturbing field and the field created by the return current;
the sheath being further **characterized in that** it includes end connectors (33) made of an electrically conductive material and assembled to the flexible tubular casing formed by the elongated elements (40), and at least one orifice (34, 35), distinct from the axial ends of the sheath (30), configured to allow passage of the cable (20).

2. The sheath according to claim 1, **characterized in that** the elongated elements (41) of the first type are made of at least one material having a relative electrical conductivity σr greater than 0.5, preferably greater than 0.6, at ambient temperature, said material being for example copper or aluminum, the relative electrical conductivity σr of a material being a dimensionless number defined as the electrical conductivity of the material divided by the electrical conductivity of copper.

3. The sheath according to any of claims 1 to 2, **characterized in that** the elongated elements (42) of the second type are made of a material belonging to the group formed by: iron, nickel, cobalt and their alloys.

4. The sheath according to any of claims 1 to 3, **characterized in that** the elongated elements (40) belong to the group comprising: round section wires, flat wires, strips, in particular rolled strips.

5. The sheath according to any of claims 1 to 4, **characterized in that**, in the sheet, the elongated elements (40) are assembled by braiding, knitting, weaving, and/or gimping.

6. The sheath according to any of claims 1 to 5, **characterized in that** the sheet is configured to be wound around the cable (20) starting from a substantially planar shape, and **in that**, preferably, it further includes means (53, 54) for holding the sheet in the wound up position.

7. The sheath according to any of claims 1 to 5, **characterized in that** the initially substantially planar sheet is formed, for example thermoformed, in a pre-wound form having a diameter in the unstressed state, and which, when placing around a cable (20), can be elastically deformed by increasing its diameter and return elastically, by reducing its diameter, to a position of use.

8. The sheath according to any of claims 1 to 7, **characterized in that** the elongated elements (41) of the first type and the elongated elements (42) of the second type are assembled to each other in the same layer (36) of the sheath (30).

9. The sheath according to any of claims 1 to 7, **characterized in that** the elongated elements (41) of the first type are located in a first layer (37) of the sheath (30) and **in that** the elongated elements (42) of the second type are located in a second layer (38) of the sheath (30), distinct from the first layer (37), coaxial with the first layer (37), and preferably located on the inner side of the first layer (37).

10. The sheath according to any of claims 1 to 9, **characterized in that** it further comprises an external textile layer (39) configured to provide mechanical protection and electrical insulation.

11. An assembly comprising a sheath (30) according to any of claims 1 to 10 and a cable (20) at least partially housed in the sheath (30), **characterized in that** the internal diameter of the sheath (30) is substantially equal to the external diameter of the cable (20).

12. An assembly comprising a sheath (30) according to any of claims 1 to 10 and a cable (20) at least partially housed in the sheath (30), **characterized in that** the section of the sheath (30) is greater than 1/10^{th}, preferably greater than 1/5^{th}, better still greater than 1/3, of the section of the cable (20).

13. An installation, such as a vehicle (1), in particular a hybrid vehicle, the installation comprising:
- a metal chassis (2);
- a current generator (10) comprising a positive terminal (11) and a negative terminal (12);
- an equipment (7), such as an electric motor, electrically connected to the chassis (2);
- an assembly according to claim 11 or 12;
in which:
- the sheath (30) includes a connector (33) made of an electrically conductive material assembled at each of the ends of the flexible tubular casing formed by the elongated elements (40), one of the connectors (33) being connected to the negative terminal (12) of the generator (10) and the other to the chassis (2), the sheath (30) including a first and a second orifice (34, 35) distinct from the ends of the flexible tubular casing;
- the cable (20) has a central portion (24) housed in the sheath (30) between the two orifices (34, 35) thereof, and passes through the orifices (34, 35) so as to present two end portions (25, 26) located outside the sheath (30), one end portion (25) being electrically connected to the positive terminal (11) of the generator (10) and the other end portion (26) being electrically connected to the equipment (7) of the installation (1), the cable (20) preferably being disposed substantially adjacent to the chassis (2), at least in its central portion (24).
